# EUROPEAN PATENT APPLICATION

(11) **EP 0 895 162 A2**
(43) Date of publication of application: **03.02.1999**
(21) Application number: 98120219.5
(22) Date of filing: 14.01.1993
(51) Int. Cl.: G06F 12/08

(54) **Enhanced dram with embedded registers**

(30) Priority: 22.01.1992 US 824211
(62) Divisional of application: 93100465.9
(71) Applicant: Enhanced Memory Systems, Inc., Colorado Springs, Colorado 80291 (US)
(72) Inventor: Sartore, Ronald H., Colorado Springs, CO 80132 (US); Carrigan, Donald G., Monument, CO 80132 (US); Jones, Oscar Frederick Jr., Colorado Springs, CO 80919 (US); Mobley, Kenneth J., Colorado Springs, CO 80908 (US)
(74) Representative: Burke, Steven David

(57) **Abstract**

An enhanced DRAM contains embedded row registers (56) in the form of SRAM cells (142, 144). The row registers (56) are adjacent to the DRAM array (40), and when the DRAM comprises a group of subarrays, the row registers (56) are located between DRAM subarrays (40). When used on-chip DRAM cache (48), these registers (56) hold frequently accessed data. This data corresponds to data stored in the DRAM (34) at a particular address. When an address is supplied to the DRAM (34), it is compared to the address of the data stored in the cache (56). If the addresses are the same, then the cache data is read at SRAM speeds. The DRAM (34) is decoupled from this read. The DRAM (34) also remains idle during this cache read unless the system opts to precharge or refresh the DRAM (34). Refresh or precharge occur concurrently with the cache read. If the addresses are not the same, then the DRAM (34) is accessed and the embedded register (56) is reloaded with the data at that new DRAM address. Asynchronous operation of the DRAM (34) is achieved by decoupling the row registers from the DRAM array (40), thus allowing the DRAM cells to be precharged or refreshed during a read of the row register (56).

## Description

The present invention relates to a dynamic random access memory ("DRAM") and more particularly to an Enhanced DRAM (which we call an "EDRAM") with embedded registers to allow fast random access to the DRAM while decoupling the DRAM from data processing operations.

As the personal computer ("PC") evolves, processor memory demands have out-paced the technology of available memory devices. One of these demands is high speed memory compatibility. Thus, memory subsystems have become an influential component toward the overall performance of a PC system. Emphasis is now on refining and improving memory devices that provide affordable, zero-wait-state operation.

With respect to memory speed, the static RAM is faster than the DRAM because the DRAM has a differential nature of the cells. In a static RAM, a differential circuit is employed directly and differential sensing is used. In a DRAM, differential techniques are used but a dummy cell or reference signal is used. Ordinarily there is no complementary data. A lesser factor is that the DRAM must refresh and precharge its memory cells whereas the static RAM need not. While the DRAM refreshes and precharges, access to the memory cells is prohibited. This creates an increase in access time, which drawback the static RAM does not suffer. On the other hand, the DRAM is less expensive and can achieve a higher density than the static RAM owing at least in part to the smaller and simpler memory cell of the DRAM. For instance, static RAMs have a maximum traditionally of one-fourth the number of cells of a DRAM which uses the same technology.

However, the speed and functionality of current DRAMS are often emphasized less than memory size (storage capacity) and cost. This is evidenced by the fact that DRAM storage capacity density has increased at a rate of an order of magnitude greater than has its speed. While there has been some improvement in access time, systems using DRAMs generally have had to achieve their speed elsewhere.

In order to increase system speed, cache memory techniques have recently been applied to DRAM main memory. A cache memory is a high-speed buffer interposed between the processor and the main memory.

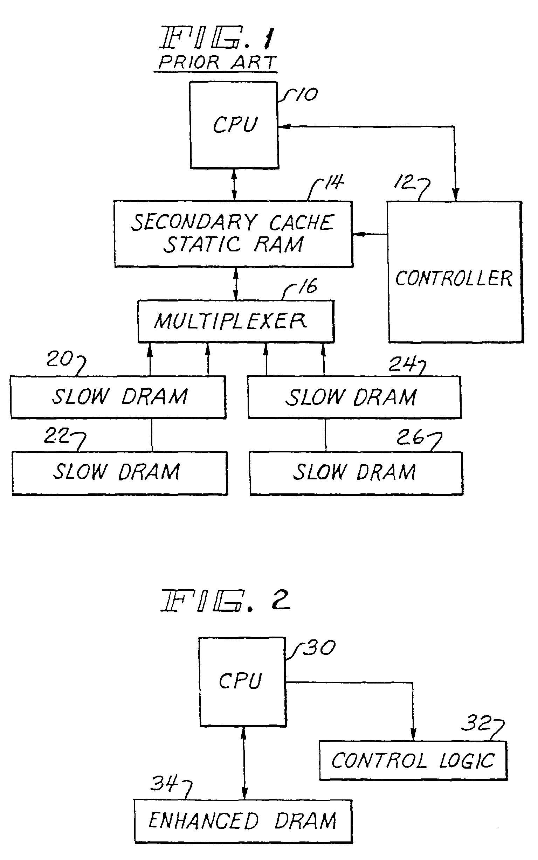

Fig. 1 indicates a prior art configuration wherein a processor 10 is configured with a cache controller 12 and a cache memory 14. The cache memory's main purpose is to maintain frequently accessed data for high speed system access. Cache memory 14 (sometimes called "secondary cache static RAM") is loaded via a multiplexer 16 from DRAMs 20, 22, 24 and 26. Subsequently, data is accessed at high speeds if stored in cache memory 14. If not, DRAMs 20, 22, 24 and/or 26 load the sought data into cache memory 14. As seen in Fig. 1, cache memory 14 may comprise a SRAM which is generally faster than DRAMS 20-26.

Various approaches have been proposed for cache memory implementation. These approaches include controlling external cache memory by a controller, such as cache memory 14 and cache controller 12 in Fig. 1, or discrete proprietary logic.

Notwithstanding its benefits, cache memory techniques complicate another major problem that exists in system design. Memory components and microprocessors are typically manufactured by different companies. This requires the system designer to effectively bridge these elements, using such devices as the cache controller 12 and the multiplexer 16 of Fig. 1. The different pin configurations and timing requirements of these components makes interfacing them with other devices difficult. Adding a cache memory that is manufactured by a yet another company creates further design problems, especially since there is no standard for cache implementation.

Exacerbating the system design problems is the disadvantage that the use of external cache memory (such as cache memory 14) compromise the main storage access speed. There are mainly two reasons for this compromise. First, and most significant, the main storage access is withheld until a "cache miss" is realized. The penalty associated with this miss can represent up to two wait states for a 50 Mhz system. This is in addition to the time required for a main memory access. Second, the prioritized treatment of physical routing and buffers afforded the external cache is usually at the expense of the main memory data and address access path. As illustrated in Fig. 1, data from DRAMs 20, 22, 24 and 26 can be accessed only through cache memory 14. The actual delay may be small, but adds up quickly.

A third problem associated with separate cache and main memory is that the time for loading the cache memory from the main memory ("cache fill") is dependent on the number of inputs to the cache memory from the main memory. Since the number of inputs to the cache memory from the main memory is usually substantially less than the number of bits that the cache memory contains, the cache fill requires many clock cycles. This compromises the speed of the system.

A memory architecture that has been used or suggested for video RAMs ("VRAMs") is to integrate serial registers with a main memory. VRAMs are specific to video graphics applications. A VRAM may comprise a DRAM with high speed serial registers allowing an additional access port for a line of digital video data. The extra memory used here is known as a SAM (serially addressed memory), which is loaded using transfer cycles. The SAM's data is output by using a serial clock. Hence, access to the registers is serial, not random. Also, there is continuous access to the DRAM so refresh is not an issue as it is in other DRAM applications.

Another implementation that is expected to come to market in 1992 is an on-chip cache memory that will use a separate cache and cache controller sub-system on the chip. It uses full cache controllers and cache memory implemented in the same way as it would be if external to the chip, i.e. a system approach. This approach is rather complicated and requires a substantial increase in die size. Further, the loading time of the cache memory from the main memory is constrained by the use of input/output cache access ports that are substantially fewer in number than the number of cache memory cells. A cache fill in such a manner takes many clock cycles, whereby system access speed suffers. Such an approach is, in the inventors' views, somewhat cumbersome and less efficient that the present invention. As example of such an implementation is disclosed in Ward et al. U.S. Patent 4,894,770. Ward et al. discloses plural data buffers to receive and store rows of data.

Still another problem in system design is interleaving memory devices when used with external cache memory. Interleaving assigns successive memory locations to physically different memory devices, thereby increasing data access speed. Such interleaving is done for high-speed system memory access such as burst modes. The added circuitry for cache control and main memory multiplexing usually required by external cache memory creates design problems for effective interleaved memory devices.

Another problem with the prior art resides in the lack of memory system salability. Adding more memory would involve adding more external SRAM cache memory and more cache control logic. For example, to double the memory size in Fig. 1, not only are more DRAM devices required, but also another multiplexer and possibly another cache controller. This would obviously add to system power consumption, detract from system reliability, decrease system density, add manufacturing costs and complicate system design.

Another problem associated with system salability arises from manufacturing the system. When using external cache memory, manufacturers allocate a certain amount of board area for the main memory. Another, smaller area is allocated for the external cache. Usually, an increase in the main memory and the external cache memory while maintaining an acceptable cache hit probability is limited. This limitation arises from the dedication of more board area for the main memory than the external cache. Therefore, salability is limited when considering acceptable cache memory hit probability.

A further problem with system speed is the need for circuitry external to the main memory to write "post" data. Post data refers to data latched in a device until it is needed. This is done because the timing requirement of the component needing the data does not synchronize with the component or system latching the data. This circuitry usually causes timing delays for the component or system latching the data.

As stated supra, access to the DRAM memory cells during a precharge and refresh cycle was prohibited in the prior art. Some prior art approaches have tried to hide the refresh in order to allow access to DRAM data. One DRAM arrangement maintained the data output during a refresh cycle. The drawback of this arrangement was that the last read data was available only during the refresh. No new data read cycle could be executed during the refresh cycle.

A pseudo-static RAM is another arrangement that attempted to hide the refresh cycle. The device was capable of executing internal refresh cycles. However, any attempted data access during the refresh cycle would extend the data access time, in a worst case scenario, by a cycle time (refresh cycle time plus read access time). This arrangement did not allow true simultaneous access and refresh, but used a time division multiplexing scheme to hide the refresh cycle.

Another way to hide the refresh cycle is to interleave the RAM memory on the chip. When a RAM memory block with even addresses is accessed, the odd memory block is refreshed and vice-versa. This type of implementation requires more timing control restraints which translate to a penalty in access time.

Another type of problem arises when considering the type of access modes to the main memory. One type of access is page mode where the addresses are synchronously input into an array after a row address has been input. The output data access time will be determined from the timing clock edge (where the column address is valid) to the appearance of the data at the output. Another type is static column mode wherein the column addresses are input asynchronously. Access can occur in these modes only when RAS is active (low), and a prolonged time may be required in the prior art.

When manufacturing chips that support these access types, only one of these access types can be implemented into the device. Usually, one of the last steps in the making of the memory chip will determine if it will support either type of access. Thus, memory chips made this way do not offer both access modes. This induces an added expense in that the manufacturer must use two different processes to manufacture the two types of chips.

To overcome these problems, small modifications added to a component, such as a DRAM, may yield an increase in system performance and eliminate the need for any bridging components. To successfully integrate the modification with the component, however, its benefit must be relatively great or require a small amount of die space. For example, DRAM yields must be kept above 50% to be considered producible. Yields can be directly correlated to die size. Therefore, any modifications to a DRAM must take into account any die size changes.

In overcoming these problems, new DRAM designs have become significant. The greatest disadvantage to caching within DRAMs has been that DRAMs are too slow. The present invention seeks to change the architecture of the DRAM to take full advantage of high caching speed that may now be obtainable.

One way to meet this challenge is to integrate the functions of the main storage and cache. Embedding the cache memory within localized groups of DRAM cells would take advantage of the chip's layout. This placement reduces the amount of wire (conductive leads) used in the chip which in turn shortens data access times and reduces die size.

It is desirable to isolate the cache memory data access operation from undesirable DRAM timing overhead operations, such as refresh and precharge.

It is also desirable to eliminate the need for an external static RAM cache memory in high speed systems.

It is also desirable to insure cache/main memory data coherency.

The present invention provides an integrated circuit memory device as set out in claim 1. Accordingly a high-speed memory device that is hybrid in its construction and is well-suited for use in high-speed processor-based systems can be provided. Preferably, tightly coupled row registers, are provided on the very same chip as the DRAM array(s). Preferably, the row registers are located within the DRAM array, and if the DRAM is configured with sub-arrays, then multiple SRAM row registers are provided for the multiple sub-arrays. Preferably the row registers are oriented parallel to DRAM rows (word lines), orthogonal to DRAM columns (bit lines). The row registers operate at high speed relative to the DRAM.

This integrated memory device preferably contains on-chip address compare circuitry, including a last read row address latch and an address comparator. Address and data latches, a refresh counter, and various logic for controlling the integrated memory device also are preferably included on the chip.

Memory reads preferably occur from the row registers. When an address is received by the memory device, the address comparator determines whether that address corresponds to an access of the row that was last read. When the address comparator detects a match ("hit"), only the row register is accessed and the data is available therefrom at SRAM speeds after the column address. Subsequent reads within the row (bursts reads, local instructions or data) will continue at that same high speed. When a read "miss" is detected, the DRAM main memory is addressed and the addressed data is written into the row register. In the event of a "miss," the data is available at the output at a slightly slower speed than a hit. Subsequent reads from the row register will have the same extremely fast access as for a hit.

Since the read is from the row register in both cases and the row register can be decoupled from the DRAM, the DRAM precharge can occur simultaneously and asynchronously without degrading performance. The refresh counter and an independent refresh, bus are implemented to allow the main memory to be refreshed during row register reads.

Memory writes are preferably directed towards the main memory. When appropriate, the on-chip address comparator will also activate a simultaneous write to the row registers. The data in the row register and the data in the main memory will be coherent for the same address. Changing rows during memory writes, in a write "hit" situation, does not affect the contents of the row register unless the row address is the same as that of the row register. This allows the system to return immediately to the row register which had been accessed just prior to the write operation. Write posting can be executed without external data latches. Page mode memory writes can be accomplished within a single column address cycle time.

Without initiating a major read or write cycle, the row registers can be read under column address control. It is preferred that the chip is activated and the output is enabled.

The toggling of the on-chip address latch by the user allows an embodiment of the present invention to operate in either a page or static column mode. Further, the zero nano-second hold allows the /RE signal to be used to multiplex the row and column addresses.

When a read hit occurs on an /RE initiated cycle, the internal row enable signal is not enabled and a DRAM access does not occur, thereby shortening the cycle time and the precharge required.

It will be understood that a novel and important aspect of the operation of such a DRAM with embedded cache memory is the provision of zero-wait state data random accesses from the cache memory while the DRAM is being refreshed or precharged, or otherwise operated asynchronously.

Another salutary aspect of the invention is that within the array structure is embedded cache memory that allows quicker cache memory fill and optimization of die density.

The invention also includes methods for operating a DRAM with embedded cache memory. A first method of operating the memory device may comprise the steps of: (1) initiating a major read or write cycle; (2) comparing the row address with the previous row address to determine whether the sought data is in the cache memory; (3) if in a read cycle, reading the data from the cache memory if it is stored there or loading the data into the cache memory from the main memory and then reading the data from the cache memory; and (4) if in a write cycle, writing only to the main memory if the data is not in the cache memory or writing to both main memory and cache memory if the data is in the cache memory.

A second method for operating the memory device may comprise the steps of: (1) refreshing a row of main memory; and (2) simultaneously and asynchronously reading the cache memory.

The invention, together with its objects and the advantages thereof, may best be understood by reference to the following detailed description taken in conjunction with the accompanying drawings of which:
Fig. 1 is a block diagram of the prior art cache implementation;
Fig. 2 is a block diagram of a circuit embodying the present invention;
Fig. 3 is a schematic block diagram of a memory device according to an embodiment of the present invention; and Fig. 4 is a detailed diagram of a row address circuit;
Fig. 5 is a detailed diagram of a column address control circuit; and
Fig. 6 is a detailed diagram part of a row register and a memory array/row register interface.

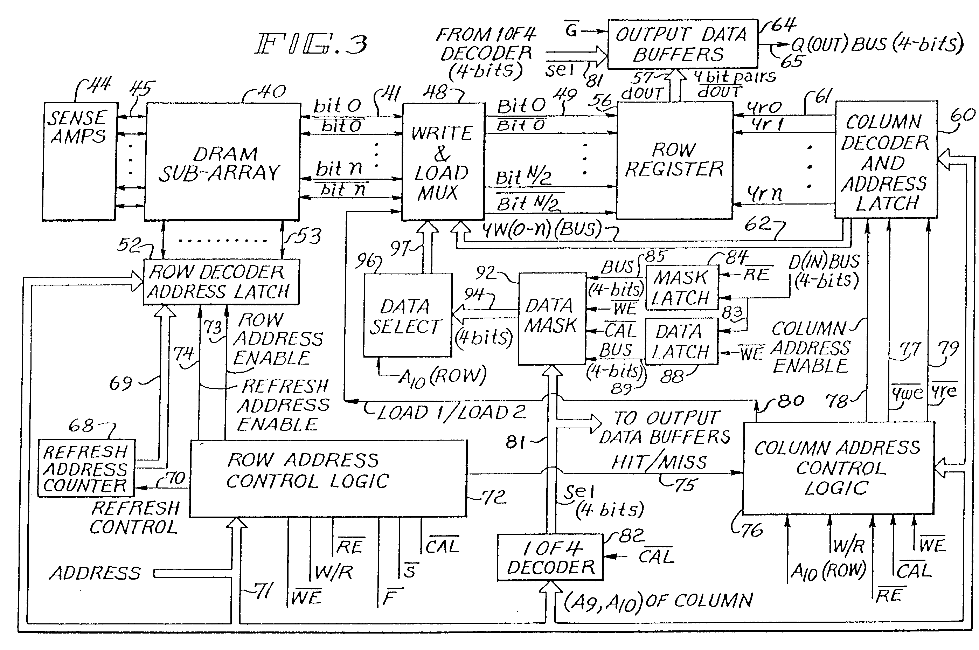

Fig. 2 is a block diagram of the preferred embodiment of the present invention. A CPU 30 is preferably connected to both control logic circuitry 32 and an EDRAM 34. As can be seen in comparison with FIG. 1, the preferred embodiment of Fig. 2 uses only three chips as compared to the eight chips of Fig. 1. This Fig. 2 arrangement provides greater system performance, lower system cost, lower system power requirement, increased system reliability, improved system density, simplified system design and easy memory system salablity.

Together with external control logic contained in control logic 32, EDRAM 34 of Fig. 2 supplants secondary cache 14, cache controller 12, multiplexer 16 and slow DRAMs 20, 22, 24 and 26 of Fig. 1. The total memory capacity of the four slow DRAM chips 20, 22, 24 and 26 can be combined onto one chip without the need for interleaving, thus eliminating the need for multiplexer 16. Further, EDRAM 34 preferably contains internal cache and cache control logic, thereby eliminating the need for secondary cache 14 and portions of cache logic 12.

With such integration of the various chip functions of the prior art, access to data in cache memory will have a zero wait-state. This fast access time will allow data transfer at high speeds (such as done in burst modes) without the need for interleaving or costly external cache memory. In addition, access to the EDRAM is preferably address sequence independent. This makes interleaving easier when used with address sequence dependent modes.

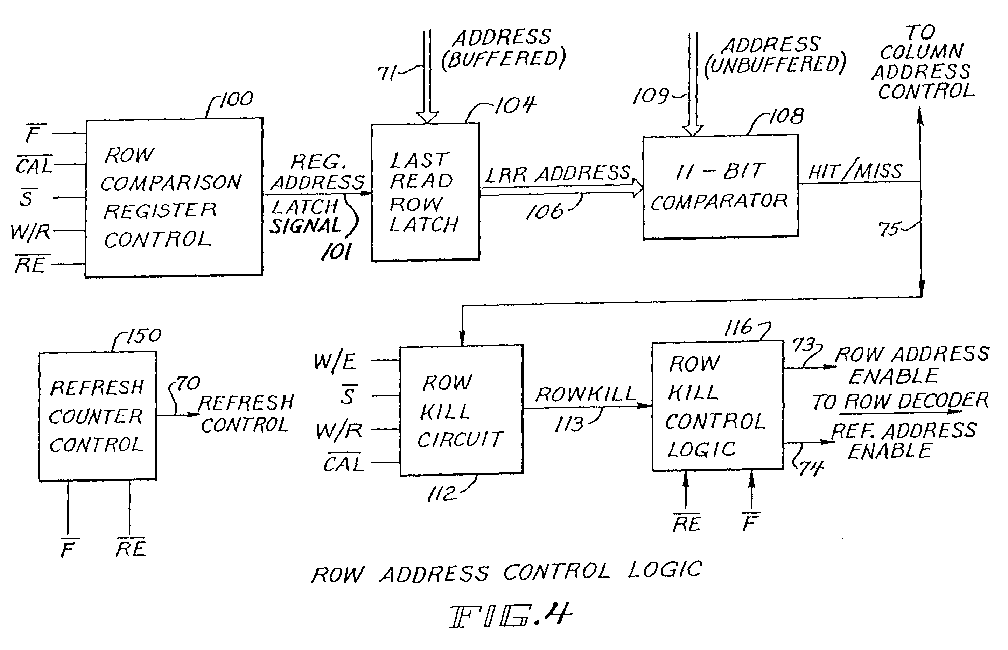

A more detailed description of EDRAM 34 will be discussed with reference to Fig. 3. EDRAM 34 preferably receives the following input signals:
- chip select signal: /S
- refresh signal: /F
- write/read signal: W/R
- row enable signal: /RE
- output signal: /G
- data signal: D
- write enable signal: /WE
- address data: A₀-A₁₀
- column address latch signal: /CAL.

An output Q is provided, illustratively four bits wide.

By way of major components, the circuit of Fig. 3 comprises a DRAM sub-array 40. Associated therewith are sense amplifiers 44 coupled to the sub-array via leads 45. From sub-array 40, a plurality of leads 41 couple data bits to a write and load multiplexer 48, which has output leads 49.

Fig. 3 also shows a row decoder/address latch 52 which is coupled via a plurality of leads 53 to DRAM sub-array 40.

A row register 56 is part of the circuit of Fig. 3. It receives signals from write and load multiplexer 48 via leads 49. Row register 56 is further coupled to receive signals from a column decoder 60 via a plurality of leads 61. Row register 56 outputs signals on leads 57 to output data buffers 64, which provide the output bus 65 of the circuit.

A refresh address counter 68 provides a plurality of signals on a bus 69 to row decoder and address latch 52. Counter 68 receives a refresh control signal via a lead 70 from row address control logic.

An address bus 71 is coupled to several blocks within Fig. 3, including row decoder 52, row address control logic 72, the column decode 60, and further circuits discussed infra. Address bus 71 illustratively receives eleven bits of address data A₀-A_{10.} This address data preferably includes 11 bits of row data and then 11 further bits of column data, or vice-versa. Alternatively but not preferably, the bus could carry a smaller number of bits of both a row and a column addresses simultaneously. Another alternative, but not preferred, is that there may be two separate address buses: one for row addresses only and the other for column addresses only.

Address data on bus 71 is also applied to a column address control logic 76. A one-of-four decode 82 preferably receives address data bits A₉ and A₁₀ from bus 71, and column address latch signal /CAL. Bus 71 is preferably multiplexed so that it carries row addresses and column addresses at respective times. Column address latch signal /CAL, chip select signal /S, refresh signal /F, row enable signal /RE, write/read signal W/R, and write enable signal /WE are connected to a row address control logic 72.

Row decode 52 preferably receives as other inputs a row address enable and a refresh address enable output from row address control logic 72. Row address enable and refresh address enable are conducted on lines 73 and 74, respectively. Row decoder 52 is coupled to memory array 40, such as to its word lines, as is well-known. The word lines (not illustrated) are preferably orthogonal to columns (bit lines) in memory array 40, which may or may not contain sub-arrays.

As further seen in Fig. 3, memory array 40 is preferably coupled via lines 45 to sense amplifiers 44, as well-known in the art, and write and load multiplexer 48. Multiplexer 48 is preferably coupled to row register 56, which is preferably located on the opposite ends of the bit lines 41 to sense amplifiers 44.

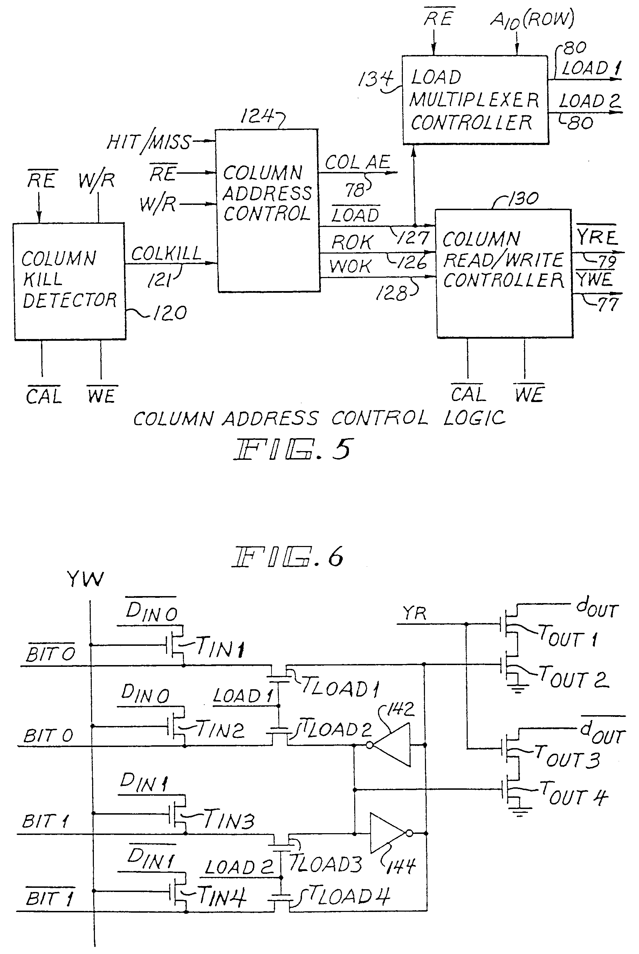

Preferably embedding row register 56 at the ends of the bit line pairs (not shown) of sub-array 40 minimally increases the die size of the preferred embodiment. Further, as illustrated in Fig. 6, two bit line pairs bit0 and /bit0, and bit1 and /bit1 are coupled to cross-coupled inverters 142 and 144 of row register 56. It will be appreciated that such cross-coupled inverters comprise a static flip-flop usable as a static memory cell. This circuit facilitates the extremely fast row register 56 fill since each of the inverter pairs, illustratively inverters 142 and 144, are selectively coupled to preferably two bit line pairs.

Preferably embedding the row register 56 and sense amplifiers 44 on respective opposing ends of the DRAM array (or sub-array) takes advantage of the impedance of the bit line pairs. This impedance helps maintain the state of sense amplifiers 44 when an unaltered write operation is performed. An unaltered write operation is where a memory bit or bits are written with a common mode high level voltage. This voltage on the bit line(s) will not cause the sense amplifiers 44 to toggle. Therefore, when the common mode high level voltage is removed from the intended unaltered bit line(s), the sense amplifier will restore the bit line(s) to the prior state.

It will be understood that the symbol "Y" connotes a column or column signal, of which there are several types (write, write enable, read, read enable). Multiplexer 48 is preferably coupled to receive write enable signals Yw from column decoder 60. Row register 56 preferably has as inputs column read signals Yr transmitted on lines 61 from column decoder 60. Row register 56 outputs Dₒᵤₜ via bus 57 to output data buffer 64. Buffer 64 also preferably receives the output enable signal /G and select bus 81 as inputs. Buffers 64 preferably outputs the output data Q on bus 65. Bus 65 is preferably 4-bits wide.

Column address control 76 preferably further receives as an input a hit/miss signal transmitted on line 75 from row address control logic 72. Control logic 76, as illustrated, outputs a load1/load2 signal to multiplexer 48 via bus 80. Control logic 76 also preferably outputs a column read enable /Yre, column write enable /Ywe and column address decode enable to decoder 60 by way of lines 79, 77 and 78, respectively. Inputs to column address control 76 also preferably include write enable signal /WE, column address latch signal /CAL, row enable signal /RE, write/read signal W/R and address bit A₁₀ preferably of row address data.

Input data D conducted on bus 83 is illustratively input to both mask latch 84 and data latch 88. Bus 83 is preferably, but not limited to, a 4-bit width. Latch 84 preferably has /RE, as an input latch enable. Latch 88 preferably has write enable /WE as an input latch enable. The outputs of both latches 84 and 88 are preferably coupled to data mask 92 along with write enable /WE and column address latch signal /CAL. As shown in Fig. 3, data mask 92 is also coupled to receive the output of decoder 82 via bus 81. Bus 81 is preferably 4-bits wide. The output of data mask 92 is coupled to data select circuit 96 through bus 94. Bus 94 is also preferred to be 4-bits wide. Select circuit 96 is preferably coupled through bus 97, preferably 4-bits wide, to multiplexer 48.

Referring now to Fig. 4, a last read row latch control 100 is preferably coupled to receive as inputs refresh signal /F, column address latch signal /CAL, chip select /S, write/read signal W/R and row enable /RE. The output of latch control 100 is illustratively connected to a last read row latch 104. Latch 104 also preferably receives row address data from bus 71. The output of latch 104 is preferably provided via a bus 106 to a comparator 108. Comparator 108 preferably compares two 11-bit address inputs, one of which is provided by latch 104. The other 11-bit address input is received preferably through a bus 109. The hit/miss signal output of comparator 108 is transmitted via line 75 to a row kill circuit 112 and column address control 76.

Row kill circuit 112 preferably receives as inputs write enable signal W/E, chip select /S, write/read signal W/R and column address latch signal /CAL. It checks the inputs to determine whether a valid read or write cycle has been initiated. If no such valid cycle has been initiated, it aborts and provides a row kill output signal to a row kill control logic circuit 116 by way of a line 113.

In addition to the row kill signal, control logic 116 preferably is coupled to receive row enable signal /RE and refresh signal /F. Control logic circuit 116 determines from these inputs whether it should enable the row decoder 52 (Fig. 3) to latch either the refresh address from refresh counter 68 or the row address from address bus 71.

Generally, row enable signal /RE when active signifies that there is a read or write access for the DRAM array 40. Refresh signal /F is active, it signifies that array 40 is to be refreshed, so row decoder 52 must latch row refresh address data. However, if the row kill signal is active, then the two outputs from control logic 116 will be inactive, which keeps the row decoder 52 from latching any address. Since no row is latched or decoded, the memory array 40 is not accessed and there is no destructive read, and no need to initiate precharge or refresh. The outputs "row address enable" and "refresh address enable" of control logic 116 are coupled via lines 73 and 74, respectively, to row decoder 52.

Fig. 5 preferably includes a column kill detector circuit 120 which preferably receives the following input signals: row enable /RE, write/read signal W/R, column address latch signal /CAL and write enable /WE. Detector 120 is preferably coupled to provide its output to a column address control circuit 124 and operates in a manner similar to row kill circuit 112. It detects whether a valid column address is received.

Control circuit 124 also preferably receives the following input signals: "hit/miss", write/read W/R, row enable /RE and column kill. From these inputs, control 124 determines whether a column read or column write is to occur. It generates four outputs, of which ROK ("read OK"), /LOAD (ENABLE), and WOK ("write OK") are coupled to a column read/write controller 130 by way of lines 126, 127 and 128 as shown in Figure 5. Further, it is preferred that line 127 is also connected to a load multiplexer controller 134. A fourth output (column address enable) of controller 124 is output over line 78 to column decoder 60.

Column read/write controller 130 also receives as further inputs write enable /WE and /CAL. Controller 130 also preferably outputs /Yre and /Ywe through lines 79 and 77, respectively, to column decoder 60.

Load multiplexer controller 134 preferably receives as inputs address bit A₁₀ and /RE. The outputs of controller 134, load1 and load2, are illustratively coupled to multiplexer 48 via lines 80.

Referring now to Fig. 6, field effect transistors are shown for illustrative purposes. Other types of transistors or switching devices may be employed. In Fig. 6, a first pair of complementary bit lines BIT0 and /BIT0, and a second such pair BIT1 and /BIT1 are coupled to memory array 40 (not shown) of Fig. 3 and to one side of the source-drain paths of write transistors Tᵢₙ₂, Tᵢₙ₁, Tᵢₙ₃ and Tᵢₙ₄, respectively. The other sides of the source-drain paths of transistors Tᵢₙ₁, Tᵢₙ₂, Tᵢₙ₃ and Tᵢₙ₄ are coupled to a select circuit output bus 97. Bus 97 is illustratively composed of Dᵢₙ₀, /Dᵢₙ₀, Dᵢₙ₁ and /Dᵢₙ₁. The gate electrodes of transistors Tᵢₙ₁, Tᵢₙ₂, Tᵢₙ₃ and Tᵢₙ₄ are coupled to Yw bus 62.

The bit lines are selectively coupled by field effect transistors or other switching devices to the latches of the row register, whereby they may be selectively decoupled. Thus, bit line pairs BIT0 and /BIT0, and BIT1 and /BIT1, the bit lines representing columns of the DRAM array, are also preferably coupled to the nearer side of the source-drain paths of T_{load1}, T_{load2}, T_{load3} and T_{load4}. Preferably, the gate electrodes of T_{load2} and T_{load1} are coupled together, as are the gate electrodes of T_{load3} and T_{load4}. The source-drain paths at the sides of T_{load1} and T_{load4} more remote from the DRAM array in Fig. 6 are coupled to the input of inverter 142, the output of inverter 144, to each other and to the gate electrode of Tₒᵤₜ₂. The similarly-situated electrodes of T_{load2} and T_{load3} are coupled to the output of inverter 142, the input of inverter 144, to each other and to the gate electrode of Tₒᵤₜ₄.

The source-drain paths of each of Tₒᵤₜ₂ and Tₒᵤₜ₄ are coupled to ground potential. The other respective source-drain electrodes of Tₒᵤₜ₂ and Tₒᵤₜ₄ are respectively coupled to respective electrodes of Tₒᵤₜ₁ and Tₒᵤₜ₃. The gates of Tₒᵤₜ₁ and Tₒᵤₜ₃ are connected to each other and to line 61, which preferably conducts Yr. The other respective electrodes of Tₒᵤₜ₁ and Tₒᵤₜ₃ are respectively coupled to bus 57.

A fuller description of the operation of the preferred embodiment will now be described. It is preferred that row enable signal /RE be the main selection input signal. When row enable signal /RE is asserted while chip select signal /S is low, all on-chip circuitry is preferably activated. When chip select signal /S is high, EDRAM 34 is in a preferred standby mode. However, a /F refresh may be performed while the chip is in a standby mode.

In order to realize the speed gains of the present invention, it is preferred that a look-ahead method be used for a row address comparison step. This is done to eliminate time delays caused by access cycles initiated before the comparison. Look-ahead requires a positive row address set-up time. The actual comparison between the previous row address and the present row address is done during a short set-up period. This preferably results in comparator 108 being able to determine close to the falling edge of row enable signal /RE if an address hit (match) has occurred. If the addresses are buffered before they are input to EDRAM 34, it is preferred that the present address to be compared to the last read row address be unbuffered. When addresses are present on chip, conventional buffering is used. But the comparator path in the preferred embodiment takes its signal directly, without buffering, from the address pins. This approach allows for the high speed address comparison before row enable /RE transitions from high to low.

Address multiplexed DRAMs usually have an zero nanosecond set-up time and a finite hold time. The preferred embodiment herein described preferably has a zero nanosecond hold time. Implementing a row enable signal /RE with a zero nanosecond hold time allows that signal to be preferably used as an address multiplexer signal. It is preferred that the user or system also compare the addresses in order that it knows the exact time that data will be present from the EDRAM.

Referring to Fig. 3, row address control 72 receives bus 71, write enable /WE, write/read signal W/R, row enable /RE, refresh signal /F, chip select /S and column address latch signal /CAL. These inputs are internally coupled in row address control 72 as shown in Fig. 4. Latch control 100 will provide an enabling signal to latch 104 only if there is a valid read cycle initiated. Preferably, latch control 100 will provide this signal if refresh signal /F and column address latch signal /CAL are high, and chip select signal /S and write/read signal W/R are low when row enable signal /RE transitions from high to low. This enable conducted on line 101 allows latch 104 to latch the last read row address, which is preferably input via bus 71. It is preferred that the latching of the last row address occur when there is a valid read cycle.

Latch 104 preferably outputs the latched address to comparator 108. Comparator 108 preferably compares the last read row address provided by latch 104 to the unbuffered present address input by way of bus 109. The state of signal hit/miss output from comparator 108 will depend preferably on the equality of the compared address.

The signal hit/miss is supplied through line 75 to row kill circuit 112. If the input signals write enable /WE, chip select /S, write/read W/R, and column address latch /CAL are not a valid input combination, or hit/miss signal is active, line 113 will make inactive row kill control logic 116, regardless of the states of the other inputs. However, lines 73 or 74 will be active depending on the states of row enable /RE and refresh /F and the inactive state of line 113. Lines 73 and 74 are supplied to decoder 52 of Fig. 3 preferably to control which, if any, address is latched into the row decoder.

Preferably, to refresh memory array 58, refresh signal /F is polled on the assertion of row enable signal /RE. When refresh signal /F is detected by the falling edge of row enable signal /RE as low, an internal refresh cycle is preferably executed. Refresh counter 68 supplies the row address field to decoder 52. Refresh counter 68 is preferably incremented at the end of the row enable signal /RE cycle in preparation for the next refreshing signal /F type refresh cycle. It is preferred that all binary combinations of address A₀-A₁₀ must be refreshed every 16 milliseconds. Also, an address bit A₁₀ preferably does not have to be cycled, but must remain valid during row address setup and hold times.

As illustrated in Fig. 4, refresh signal generator 150 preferably has as inputs refresh /F and row enable /RE. It is preferred that refresh signal /F be active when row enable /RE transitions from high to low. The output of generator 150, if active, will be provided to increment counter 68 of Fig. 3 when the device is performing a row refresh. The value of counter 68 will preferably be continually supplied to decoder 52.

Decoder 52 will latch and decode either the refresh address supplied by line 69 or the present row address supplied by bus 71, depending on the states of lines 73 and 74. Decoder 52 and sense amplifiers 44 communicate with sub-array 40 as well known in the art to either input or output bit values on lines 41.

As illustrated in Fig. 6, the different access cycles will be now be explained. Preferably, when there is a hit on a read cycle, load signals Load1 and Load2 are not active. This causes load transistors Tload1, Tload2, Tload3 and Tload4 to be off, thereby decoupling inverters 142 and 144 from bit pair line bit0 and /bit0, and bit1 and /bit1. Shown in Fig. 6 are two bit line pairs provided by lines 41 and coupled to inverters 142 and 144. The scope of this invention is not limited to the ratio of two bit line pairs to one pair of inverters.

Column write address signal Yw remains inactive which maintains input transistors Tin1, Tin2, Tin3 and Tin4 off. Thus the sub-array 40 (not shown) is isolated from the read. This isolation does not cause sub-array 40 to destructively discharge, hence another access to sub-array may occur quicker than if an access had occurred. Column read address signal Yr is active, which preferably activates Tout1 and Tout3 such that data at the gates will be an inverted output on lines dout and /dout. A write to sub-array may occur when inverters 142 and 144 are decoupled and being read.

In the case where there is a read with a miss, then the load transistors Tload1, Tload2 or Tload3 and Tload4 are turned on by load signal Load1 or Load2 being active. This will transfer data provided on either bit line pairs of lines 41 to the inverter pairs 142 and 144. The read cycle then preferably proceeds as above.

For a write cycle with a miss, load signals Load1 and Load2 preferably do not turn on load transistor Tload1, Tload2, Tload3 and Tload4. Instead, column write enable signal Yw turns on input transistors Tin1, Tin2, Tin3 and Tin4. This causes data on supplied by bus 97 to be input to sub-array 40. As this write occurs, reads of the decoupled inverters 142 and 144 may occur.

When a write cycle with a hit is determined, the steps for the write miss described supra are the same except that load signals Load1 or Load2 turn on load transistors Tload1, Tload2 or Tload3 and Tload4. The data provided on bus 97 will then be written to both sub-array 40 and inverters 142 and 144. The reading of the inverters 142 and 144 may be done during this cycle.

When the user determines that the data to be read is maintained by inverters 142 and 144, a read of those inverters can be accomplished without initiating a row enable /RE type cycle. The user, as will be explained infra, must activate chip select signal /S, output enable signal /G and must present valid column addresses. In this manner, the data maintained on inverters 142 and 144 can be read by simply activating the output transistors Tout1 and Tout3 with column read address signal Yr.

Further, as this non-/RE type cycle proceeds, it is preferred that the sub-array may be simultaneously and asynchronously accessed while the DRAM is performing a /F-type refresh or during the time that the DRAM is in precharge following read/write cycles. This is possible since the load transistors Tload1, Tload2, Tload3 and Tload4 are not active, which decouples inverters 142 and 144 from the bit line pairs of lines 41.

Referring now to Fig. 3, when data is provided on lines 57 (illustratively 2 bit pairs wide per register), buffer 64 will be enabled by bus 81 and output enable signal /G. Data will then be supplied to bus 65 (illustratively 4 bits wide). Buffer 64 can also preferably post the output data.

Referring now to column address control logic 76 of Fig. 3, a more detailed description of its preferred operation will be explained with reference to Fig. 5. Column kill detector 120 will be active when the states of inputs row enable /RE, write/read signal W/R, column address latch signal /CAL and write enable /WE are an invalid write cycle. The signal generated by detector 120 will ultimately disable the operation of column decoder 60 of Fig. 3.

Column address control 124 generates a read enable signal on line 126, a column latch enable on line 78, a load enable signal on line 127 and a write enable signal on line 128. The generation of these signals is preferably responsive to the states of inputs hit/miss, write/read W/R and the output of detector 120 when row enable /RE transitions. It should be known that toggling input /CAL to detector 120 will cause the column address enable signal on line 78 to toggle. Toggling line 78 enables the latch (not shown) in column decoder 60 of Fig. 3. Enabling this latch will allow for fast page mode or static column mode access to row register 56 of Fig. 3. Operation in a static column mode can continue into the next row enable signal /RE cycle with no access tame penalty if the row address remains the same as the previous cycle.

The data latching also releases the system's need to persist with the holding of the data, thus eliminating the system's need for external write data post latch circuitry. Further, data latching in conjunction with the decoupling of the cache memory allows for many write/read situations to achieve continual zero wait-state operations for, as an example, an odd/even word interleave arrangement. Once input data is latched in latch 88, the device can ignore the logic state of the data-in pin D. This permits subsequent access to the cache contents concurrent with the internal, physical write.

The use of column address latch signal /CAL during the write cycles allows early posting of input data, latched by write enable signal /WE, prior to the presence of a valid column address. This eliminates the need for external write posting by the system. Any subsequent writes must have another column address input. Controller 130 generates outputs on lines 77 and 79 that enable the column decoder 60 of Fig. 3 to either provide a read or write column address to the circuitry in Fig. 6. Lines 77 and 79 will be active if input lines 126 or 128 are active, which are controlled by write/read signal W/R, and inputs /CAL and /WE are active.

Line 127 output from controller 124 enables controller 134 to generate signals Load1 or Load2, which are provided to multiplexer 48 of Fig. 4. Load1 or Load2 are determined by the state of input A₁₀ when /RE transitions.

Referring now to Fig. 3, decoder 60 will latch the address provided by bus 71 if line 78 is active, which address will be subsequently decoded. Decoder 60 will provide active signals conducted by lines 61 to row register 56 if line 79 is active, which reflects a memory read. Preferably, decoder 60 will provide active signals on lines 62 to multiplexer 48 if line 77 is active, which reflects a memory write.

Referring now to the data-in path, input data on bus 83 is supplied to mask latch 84 and data latch 88. Bus 83 is preferably four bits wide. Latch 84 will capture the mask input data when /RE transitions. Mask input data is used when the user requires that less than the four addressed memory bits are to be written. Latch 88 will capture the input data when /WE becomes active. The outputs of latches 84 and 88 are input, along with /CAL and /WE to data mask circuit 92. Circuit 92 also receives bus 81, preferably four bits wide. Circuit 92 will output the data from latch 88 that is not masked by latch 84. The bits that are masked are output to data select circuit 96 in a predetermined state.

When the device is used as a 1-bit wide memory, decoder 82 will output a select signal on bus 81, preferably determined by row address bits A₉ and A₁₀. Mask circuit 92 will then output the selected bit determined by the state of bus 81. Of the four input bits provided by bus 94, two will be selected based preferably on the state of row address A₁₀ Preferably, these selected and unselected bits will be output to multiplexer 48.

In the case where the row and column addresses are not multiplexed, the row and column addressed can be presented at the same time. Access time for a /RE read access where a hit occurs can have the same access as a row register access were /RE has not been asserted. With /RE internally terminated on a hit, the row register 56 is not coupled to DRAM 40 and can be accessed as soon as a column address is available.

Numerous modifications or alterations can be made. For example, instead of multiplexing two bits on the same storage cell of row register 56, as shown in fig. 6, each bit line pair in output from DRAM sub array 40 may be coupled to dedicated storage cell in which case, the row register 56, rather than storing half the number of bits which may be simultaneously read out from DRAM sub array 40 (half row), will store the full row.

## Claims

1. A method of operating an integrated circuit memory having a DRAM portion, an on-chip cache portion coupled to the DRAM portion, and a plurality of connection pins, comprising the steps of:
(a) reading from the on-chip cache portion including the sub-steps of:
applying row and column addresses to a plurality of address pins,
applying input data to a plurality of data pins in connection with a storing step where the input data is to be stored in the DRAM portion,
receiving output data from said data pins representing data stored in the integrated circuit memory,
applying a column address latch signal to a column address latch pin to control a column address latch in the integrated circuit memory,
applying a chip select signal to a chip select pin for enabling the on-chip cache portion to be activated so that data can be read therefrom without requiring access to the DRAM portion, and
applying a row enable signal to a row enable pin to permit the DRAM portion to be accessed for writing to or reading from the DRAM portion; and
(b) precharging the DRAM portion, wherein steps (a) and (b) are performed contemporaneously.

2. The method as claimed in claim 1, wherein the step of reading further comprises the sub-step of:
applying an output enable signal to an output enable pin to cause the integrated circuit memory to enable output circuits thereon.

3. The method as claimed in claim 1, wherein the step of reading further comprises the sub-step of:
determining on chip whether the integrated circuit memory will operate in static column mode or page mode on the basis of the state of said column address latch signal.

4. A method for data storage access in a memory chip including an integrated circuit cache memory and an integrated circuit memory array, the method comprising the steps of:
reading from the integrated circuit cache memory;
decoupling the integrated circuit memory array from the integrated circuit cache memory simultaneously with said reading step; and
asynchronously precharging the integrated circuit memory array contemporaneously with said reading step.

5. The method of claim 4, further comprising the step of refreshing the integrated circuit memory array during said reading from the cache memory.

6. A method for operating an integrated circuit memory device including a dynamic random access memory array having a single row decoder, a single column decoder responsive to an externally supplied address signal on an address bus for accessing a specified subset of memory cells within said memory array, a bidirectional data bus for providing a signal indicative of data associated with the specified subset of memory cells, an input/output control and data latch circuit responsive to an externally applied write enable signal and being coupled to input and output buses of the bidirectional data bus, a memory cache for storing a row of the data associated with the specified subset of memory cells last accessed from the memory device and coupled to the input and output buses and to an associated column write select circuit and interposed between the single column decoder and the memory array, wherein corresponding locations in rows of both the memory cache and the memory array may be accessed by the single column decoder, and wherein data read from the memory device is read out of the memory cache only and data written to the memory device is written to the memory array, the method comprising the steps of:
reading from the memory cache;
decoupling the memory array from the memory cache simultaneously with said reading step; and
asynchronously operating the memory array contemporaneously with said reading step.

7. The method as claimed in claim 6, wherein the step of asynchronously operating comprises the step of asynchronously refreshing the memory array during said reading step.

8. The method as claimed in claim 6, wherein the step of asynchronously operating comprises the step of asynchronously precharging the memory array during said reading step.

9. A memory chip comprising:
an integrated circuit cache memory;
an integrated circuit memory array;
an output circuit for outputting data from the integrated circuit cache memory;
a decoupling circuit for decoupling the integrated circuit memory array from the integrated circuit cache memory when data is being output from the output circuit; and
a precharging circuit coupled to the decoupling circuit for precharging the integrated circuit memory array contemporaneously with the output circuit outputting data from the integrated circuit cache memory.

10. The memory chip as claimed in claim 9, further comprising a refresh circuit coupled to the decoupling circuit for refreshing the integrated circuit memory array contemporaneously with the output circuit outputting data from the integrated circuit cache memory.

11. An integrated circuit memory device comprising:
a memory array;
a cache integrated within and coupled for direct mapping by row address to said memory array;
a column address latch coupled to said memory array;
an address input coupled to said column address latch;
a last row read address latch coupled to said cache and said address input;
a comparator coupled to said last read row address latch and said address input;
a row address latch coupled to said memory array and said address input;
a refresh counter coupled to said memory array;
an input and output control circuit coupled to said memory array and said cache;
an output coupled to said input and output control circuit; and
a plurality of input/output data lines, and masking circuitry so that said plurality of input/output data lines are maskable.

12. An integrated circuit memory comprising:
a plurality of connection pins;
an integrated circuit connected to said connection pins, the integrated circuit including a plurality of DRAM memory cells arranged in an array, a plurality of row registers coupled selectively to said array, a coupling circuit connected between said array and said row registers and effective for selectively coupling and decoupling the array from the row registers, a row decoder coupled to said array, a refresh circuit coupled to said array a precharging circuit coupled to said coupling circuitry for allowing said array to be precharged while at least one of said plurality of row registers is accessed, a column decoder, a plurality of sense amplifiers coupled to said array, and at least one output data buffer;
wherein said plurality of pins includes:
a plurality of address pins for receiving row and column addresses;
a plurality of power supply pins for receiving power supply voltages;
a plurality of data pins for receiving and outputting data bits;
a chip select pin for receiving a chip select signal;
a write enable pin for receiving a write enable signal;
a row enable pin for receiving a row enable signal; and
a column address latch pin for receiving a column address latch signal.

13. A method of operating an integrated circuit memory having a DRAM portion, an on-chip cache portion coupled to the DRAM portion, and a plurality of connection pins, comprising the steps of:
applying row and column addresses to a plurality of address pins;
applying input data to a plurality of data pins in connection with a storing step where the input data is to be stored in the DRAM portion;
receiving all output data only from the on-chip cache portion of the integrated circuit memory via said plurality of data pins;
applying a chip select signal to a chip select pin for enabling the on-chip cache portion to be activated so that data can be read therefrom without requiring access to the DRAM portion; and
applying a row enable signal to a row enable pin to permit the DRAM portion to be accessed for writing to or reading from the DRAM portion.

14. A method for data storage access comprising the step of:
inputting a row address to a single chip memory device;
on said single chip, comparing said row address to a last read row address;
if said row address and said last read row address are equal, terminating internally a main selection input signal, reading from a cache located on said single chip memory device, and outputting from said cache without reading from a memory array portion of the single chip memory device.

15. An integrated circuit memory device comprising:
a memory array;
a cache integrated within and coupled for mapping by row address to said memory array;
a column address latch coupled to said memory array;
an address input coupled to said column address latch;
a row address latch coupled to said memory array and said address input;
an input and output control circuit coupled to said memory array and said cache;
an output coupled to said input and output control circuit; and
a plurality of input/output data lines, and masking circuitry so that said plurality of input/output data lines are maskable.

16. The integrated circuit memory device as claimed in claim 15, further comprising:
a last row read address latch coupled to said cache and said address input.

17. The integrated circuit memory device as claimed in claim 16, further comprising:
a comparator coupled to said last read row address latch and said address input.

18. The integrated circuit memory device as claimed in claim 15, wherein the cache integrated within and coupled for mapping by row address to said memory array comprises a cache integrated within and coupled for direct mapping by row address to said memory array.

19. The integrated circuit memory as claimed in claim 12, further comprising:
a refresh control signal pin for receiving a refresh control signal.

20. The integrated circuit memory as claimed in claim 12, further comprising:
an output enable pin for receiving an output enable signal.

21. The integrated circuit memory as claimed in claim 12, further comprising:
a read/write control pin for receiving a read/write control signal.

22. A memory chip comprising:
a cache;
a memory array coupled to the cache and for outputting data based on a main selection input signal;
row address pins for receiving a row address applied to the memory chip;
a comparator for comparing the row address to a last read row address and outputting a positive result if the row address and the last read row address are equal;
an internal cache controller responsive to the positive result of the comparator, the internal cache controller including (a) a terminator for unasserting a main selection input signal and (b) an output circuit for outputting data from the cache without reading from the memory array.
